# EUROPEAN PATENT APPLICATION

(11) **EP 4 451 327 A1**
(43) Date of publication of application: **23.10.2024**
(21) Application number: 24170022.8
(22) Date of filing: 12.04.2024
(51) Int. Cl.: H01L 23/495, H01L 21/48, H01L 21/56

(54) **METHOD OF MANUFACTURING SEMICONDUCTOR DEVICES, CORRESPONDING SUBSTRATE AND SEMICONDUCTOR DEVICE**

(30) Priority: 20.04.2023 IT 202300007716
(71) Applicant: STMicroelectronics International N.V., 1228 Plan-les-Ouates, Geneva (CH)
(72) Inventor: MAZZOLA, Mauro, 24040 Calvenzano (Bergamo) (IT)
(74) Representative: Buzzi, Notaro & Antonielli d'Oulx S.p.A.

(57) **Abstract**

An electrically conductive substrate (12) for a plurality of semiconductor devices (10) has mutually opposed first (121) and second (122) surfaces and comprises electrically conductive die pads (12A) configured to have semiconductor chips (14) arranged thereon as well as arrays of electrically conductive leads (12B) arranged around the electrically conductive die pads (12A). The substrate (12) comprises elongated electrically conductive connecting bars (100) connected to the electrically conductive die pads (12A). The elongated connecting bars (100) are configured to be cut (B) at intermediate points (SL) along their length to provide singulated substrate portions and have distributed along their length first recesses (121A) at the first surface (121) alternating with second recesses (122A) (121A, 122A) at the second surface (122). Once cut (B) at the intermediate points (SL), the elongated connecting bars (100) are partitioned into bar remainders (100') extending from a distal end (100A) to an electrically conductive die pad (12A) in a singulated substrate portion. The bar remainders (100') have a serpentine pattern with one or more loops between their distal end (100A) exposed at the surface of the insulating encapsulation (20) of the device package and the electrically conductive die pad (12A), thus creating tortuous paths (WPP') countering moisture penetration into the device package. The elongated connecting bars (100) comprise a sequence of adjacent sections having the first recesses (121A) and the second recesses (122A) etched therein, with these adjacent sections alternately located at the opposed first (121) and second (122) surfaces, wherein dummy pads (120A) left exposed by the encapsulation (20) are formed at the second surface (122).

## Description

### Technical field

The description relates to manufacturing semiconductor devices.

Solutions as described herein can be applied to (integrated circuit, IC) semiconductor devices such as power QFN packages, for automotive products, for instance.

### Background

Delamination, typically at the interface between different package materials, is an issue likely to arise in reliability tests of semiconductor devices. A device may fail as a result of delamination reaching the die area.

Water (moisture) infiltration into a device package during the device lifetime is observed to represent a possible source of delamination. Back side or front side grooves along the die pad periphery have been proposed to slow down delamination close to the critical die area.

In current manufacturing processes of (integrated circuit) semiconductor devices, multiple devices are concurrently processed and finally singulated into individual devices.

During processing, multiple devices are held together in a strip using metallic connecting structures including connecting bars running along the periphery of each device.

A singulation step is performed via sawing along vertical and horizontal sawing lines (for instance, after assembly of the devices and subsequent molding) at the connecting bars. Water (moisture) penetration may take place at tie bars connecting, for instance, die pads where semiconductor chips are attached.

Remainders of tie bars severed during package singulation in producing individual manufacturing semiconductor products remain that extend from the leadframe to the outer surface of the device package, thus providing straight penetration paths from the outer surface of the device package to a die attached to a leadframe.

Document US 7 153 724 B1 discloses a series of grooves etched in a leadframe to be used in fabricating a group of semiconductor packages. The grooves are etched at locations where the leadframe will later be sawed to separate the semiconductor packages. In variations of the process, the grooves may be wider or narrower than the kerf of the saw cuts and may be formed on the side of the leadframe facing towards or away from the entry of the saw blade.

Document US 2005/093117 A1 discloses a plastic package including a plurality of terminal members each having an outer terminal, an inner terminal, and a connecting part connecting the outer and the inner terminal. The plastic package includes also a semiconductor device provided with terminal pads connected to the inner terminals with bond wires and a resin molding sealing the terminal members, the semiconductor device and the bond wires therein. The inner terminals of the terminal members are thinner than the outer terminals and have contact surfaces. The upper, the lower and the outer side surfaces of the outer terminals, and the lower surfaces of the semiconductor device are exposed outside. The inner terminals, the bond wires, the semiconductor device and the resin molding are included in the thickness of the outer terminals.

The documents discussed above disclose meander-like structures provided at the leads (or terminals) of a semiconductor device.

### Object and summary

Solutions as described herein aim at addressing the issues discussed in the foregoing.

Such an object can be achieved via a method having the features set forth in the claims that follow.

One or more embodiments relate to a corresponding substrate, suited to be supplied by a supplier to manufacturers of semiconductor devices for use in manufacturing (integrated circuit) semiconductor devices.

One or more embodiments relate to a corresponding (integrated circuit) semiconductor device.

The claims are an integral part of the technical teaching provided in respect of the embodiments.

Solutions as described herein involve the recognition that, in addition to a humidity entry point, an exposed tie bar may also represent a fragile point due to damages caused during sawing (crack initiation).

Solutions as described herein propose a die pad structure that counters humidity/delamination.

In various embodiments, a tie bar may comprise a meander-like (serpentine or snake-like) portion. In various embodiments, such a snake-like (or zig-zag) structure can be formed in a leadframe, by half-etching from both sides.

Various embodiments result in a longer path for humidity/delamination to reach the die area.

Advantageously, in various embodiments, one or more additional dummy pads can be created that increase the thermo-mechanical robustness of the adjacent solder joints.

### Brief description of the several views of the drawings

One or more embodiments will now be described, by way of example only, with reference to the annexed figures, wherein:
Figure 1 is a plan view illustrative of the structure of an integrated circuit (power)semiconductor device,
Figures 2 to 6 are illustrative of steps in manufacturing integrated circuit semiconductor devices, where Figure 2 is a cross-sectional view along line II-II in Figure 1 and Figure 6 is a lateral view according to arrow VI in Figure 5,
Figure 7 is an enlarged partial cross-sectional view of an integrated circuit semiconductor device that can be obtained with the steps of Figures 2 to 6,
Figures 8 to 12, where Figure 12 is a lateral view according to arrow XII in Figure 11, are illustrative of steps in manufacturing integrated circuit semiconductor devices according to embodiments of the present description,
Figure 13 is an enlarged partial cross-sectional view of an integrated circuit semiconductor device obtainable with the steps of Figures 8 to 12, and
Figures 14 and 15 are perspective views illustrative of possible features of an integrated circuit semiconductor device obtainable via embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination or the extent of the feature.

### Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

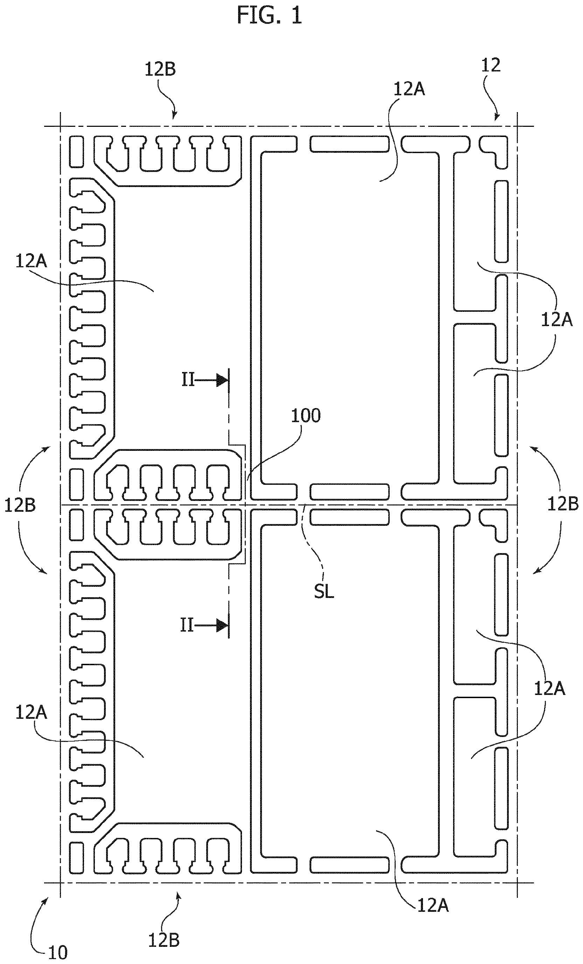

Figure 1 illustrates the structure of an integrated circuit (IC) semiconductor device 10, by referring to a substrate (leadframe) configured to define the device structure. That is, Figure 1 is a plan view of such a substrate where other elements making up the device 10 (as discussed in the following) are not visible for simplicity.

The IC semiconductor device considered herein, merely by way of example, is a power device comprising:
a low-power section (on the left-hand side of Figure 1) with, for instance, a controller die or chip attached on a first die pad 12A in a leadframe 12, and
a high-power section (on the right-hand side of Figure 1) with, for instance, one or more power dice or chips attached on one or more second die pads in the leadframe 12.

The second die pads are likewise designated 12A for simplicity, being otherwise understood that the specific layout of the die pads 12A illustrated herein is merely exemplary and non-limiting. Also, as used herein, the terms chip/s and die/dice are regarded as synonymous.

An array of leads 12B is arranged around the die pads 12A having the low-power and the high-power dice mounted thereon.

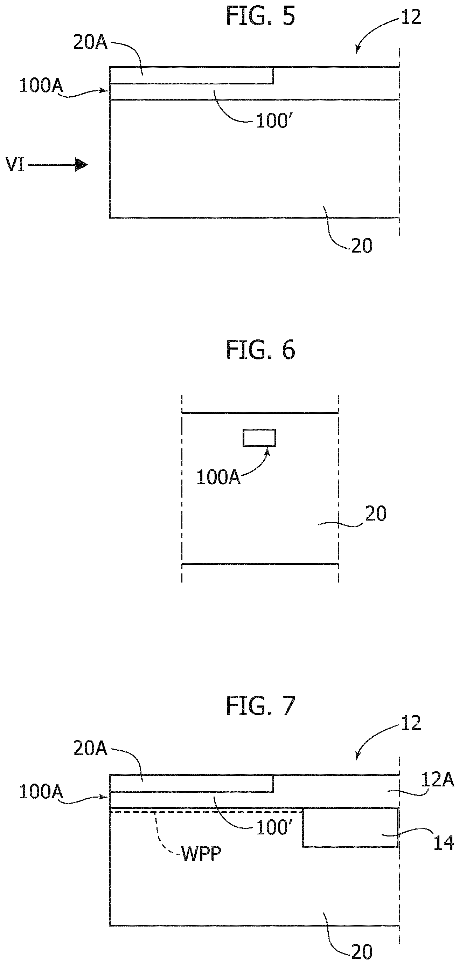

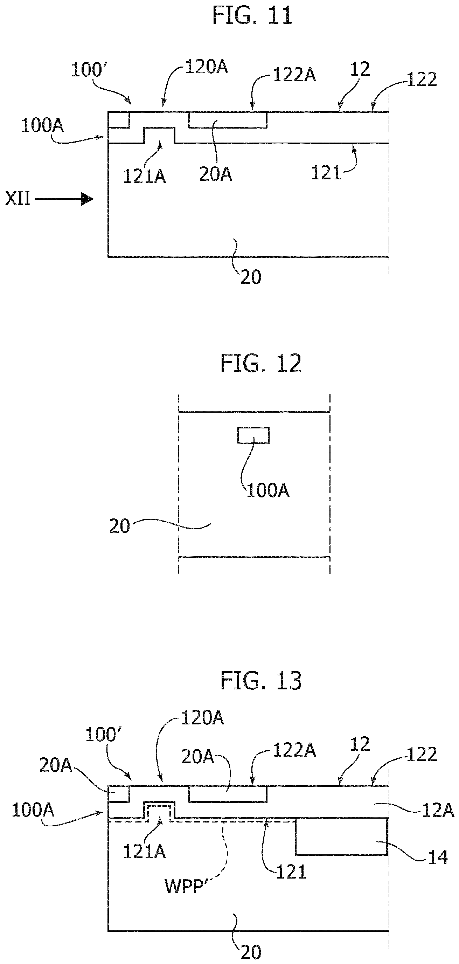

An IC semiconductor device such as the device 10considered herein by way of example comprises, in addition to a substrate (leadframe) 12 as visible in Figure 1:
one or more semiconductor chips or dice 14 (for simplicity, these are visible only in the enlarged partial cross-sectional views of Figures 7 and 11):
electrically conductive formations coupling the semiconductor chip(s) 14 to leads (outer pads) 12B in the substrate, and
an insulating encapsulation 20 molded on the assembly thus formed to complete the plastic body of the device 10.

The designation "leadframe" (or "lead frame") is currently used (see, for instance the USPC Consolidated Glossary of the United States Patent and Trademark Office) to indicate a substrate including a metal frame that provides support for an integrated circuit chip or die as well as electrical leads to interconnect the integrated circuit in the die or chip to other electrical components or contacts.

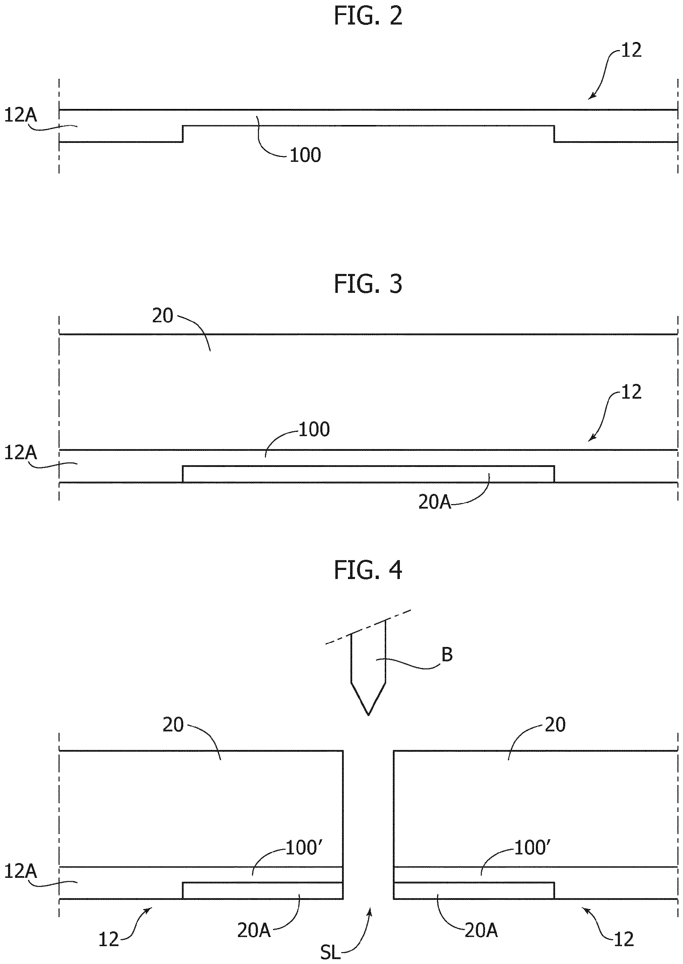

Essentially, a leadframe 12 comprises an array of electrically-conductive formations (or leads, for instance, 12B) that from an outline location extend inwardly in the direction of a semiconductor chip or die (for instance, 14) thus forming an array of electrically-conductive formations from a die pad (for instance, 12A in Figure 4) configured to have at least one (integrated circuit) semiconductor chip or die attached thereon. This may be via conventional means such as a die attach adhesive (a die attach film or DAF, for instance).

In embodiments as illustrated herein by way of example, a leadframe 12 can be of the pre-molded type, that is a type of leadframe comprising a sculptured metal (for instance, copper) structure formed by etching a metal sheet and comprising empty spaces that are filled by an insulating compound 20A (a resin, for instance) "pre-molded" on the sculptured metal structure.

In current manufacturing processes of (integrated circuit) semiconductor devices plural devices/leadframes are processed concurrently.

Figure 1 is generally exemplary of a conventional manufacturing process of IC semiconductor devices, wherein a plurality of individual leadframe portions are provided as a common electrically conductive substrate for use in manufacturing a plurality of semiconductor devices.

For instance, such common electrically conductive substrate can be provided as a plurality of individual leadframes held together in a leadframe strip via connecting formations SL extending around the individual leadframe portions. As illustrated in Figure 1, further connecting formations 100 (oftentimes referred to as "tie bars") connect the die pads 12A to the connecting formations SL.

These connecting formations 100, SL are formed with reduced thickness during manufacturing the sculptured electrically conductive structure (of a metal such as copper, for instance) of the leadframe 12. The related processing may involve (chemical, for instance) etching of a base metal layer (foil or strip).

For that reason, tie bars can be regarded as "half-etched" portion of such a metal layer: however, referring to "half" etching does not imply that the etched depth amounts necessarily to 50% of the thickness of the metal layer or strip.

A process for manufacturing a semiconductor device as exemplified herein thus essentially involves providing a common electrically conductive substrate 12 (for instance, a leadframe strip) for a plurality of semiconductor devices.

In current manufacturing processes of integrated circuit semiconductor devices, a (fairly high) number multiple devices are concurrently processed and finally singulated into individual devices.

For simplicity, and merely by way of example, the structure of two such neighboring semiconductor devices is illustrated surrounded by chain lines in the plan view of Figure 1.

This facilitates appreciating that processing as considered herein may involve:
attaching semiconductor chips or dice 14 on respective die pads 12A of a leadframe 12 (possibly of the pre-molded type with a pre-mold resin 20A as exemplified by the sequence of Figures 2 and 3),
providing electrically conductive formations (such as wires, ribbons or clips - not visible for simplicity in the figures) between the semiconductor chips or dice 14 on respective die pads 12A and the leads 12B,
molding an insulating encapsulation 20 (for instance, an epoxy resin, as illustrated in Figure 3) on the assembly thus formed in order to complete the plastic body of a plurality of devices 10 formed on the common substrate (leadframe) 12, and
"singulating" these devices into individual (integrated circuit) semiconductor devices 10 by cutting (for instance, with a sawing blade B) along "horizontal" and "vertical" cutting (sawing) lines SL (that is, by removing the connecting formations SL).

In Figures 2 to 4 just a piece of the common substrate 12 is visible for simplicity with one cutting line SL along the connecting formations running between adjacent substrate portions in the common electrically conductive substrate (leadframe) 12.

As illustrated in these figures, the adjacent substrate portions in the common electrically conductive substrate 12 have mutually facing sides and are connected (prior to singulation) via elongated connecting bars (or tie bars) 100 connecting adjacent substrate portions (die pads 12A, for instance) to the connecting formations SL extending between the mutually facing sides.

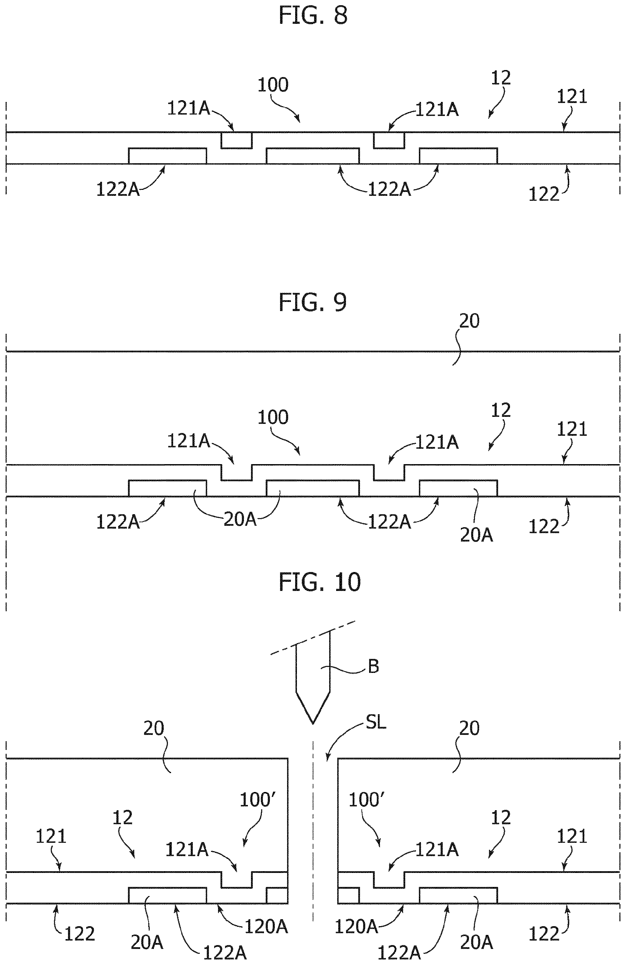

Singulating the devices 10 into individual semiconductor devices by cutting along cutting (sawing) lines SL as illustrated in Figure 4 and 10 involves cutting the electrically conductive substrate 12 across the length of the elongated ("half-etched") connecting bars 100 that are thus severed crosswise at intermediate points therein.

As visible in Figures 5 and 6, for instance, in response to such a singulation step, the connecting bars 100 are severed at an intermediate point of their length thus forming two tie bar remainders 100' each having a "distal" end portion 100A exposed at the surface of the packages provided by the molding compound 20 (resin).

In so far as discussed in the foregoing, concurrent processing of plural semiconductor devices to be finally "singulated" is conventional in the art, which makes it unnecessary to provide a more detailed description herein.

As discussed in the introductory portion of this description, water (moisture) infiltration into a device package during the device lifetime is observed to represent a possible source of delamination.

Water (moisture) penetration may take place at tie bars 100 connecting, for instance, die pads where semiconductor chips are attached. Remainders 100' of tie bars severed during package singulation (see Figure 4) in producing individual manufacturing semiconductor products thus remain that extend from the leadframe (die pad 12A) to the outer surface of the device package (molding compound 20).

This ends up by providing straight water (moisture) penetration paths (indicated by reference WPP in Figure 7) from the outer surface of the device package, namely from the distal end 100A of the remainders 100' of the tie bars 100 to a die 14 attached to a leadframe 12. In Figure 7, such a die is shown attached under (in fact to the front surface of) a die pad 12A.

As discussed, delamination, typically at the interface between different package materials, is an issue likely to arise in reliability tests of semiconductor devices. As a result of delamination reaching the die area, a device such as the device 10 considered herein may fail.

Water (moisture) infiltration into a device package from a distal end 100A of a tie bar remainder 100' along a (rectilinear) water (moisture) penetration path WPP as illustrated in Figure 7 during the device lifetime may represent a possible source of delamination.

During its useful lifetime, a device package as illustrated herein can be exposed to a humid environment, and some humidity (moisture) can penetrate the package starting from possible "open" points such as an exposed tie bar (at a distal end 100A, for instance), where water molecules can infiltrate the package through small passageways produced during singulation.

Over time, water can run along the leadframe structure, undergoing expansion and shrinking in response to temperature variations, thus causing interface detachment and delamination. When delamination reaches the die area, the device is highly likely to fail.

These problems may be attempted to be palliated in various ways, for instance by reducing the level of exposure of the package to humidity, by changing the leadframe properties (material and roughness, for instance), or by using a resin with improved adhesion as the molding compound 20.

These approaches may have a negative effect on package performance and/or lead to an increased package cost.

Document US 6329706 B1 discloses a lead frame and a semiconductor package adopting the leadframe, capable of effectively preventing moisture intrusion into the semiconductor package, and preventing flashing and reducing thermal stress on a chip pad during a molding process. The chip pad of the leadframe includes at least two swaged portions having narrow and long grooves on the first and second surfaces thereof, formed in a V-like or U-like shape along the four sides of the chip pad in a rectangular shape. At least one slot is formed along the outside of a chip mount area with wings adjacent to the slots.

Document US 6229205 B1 discloses a semiconductor device package that includes a tie bar for supporting a die pad with a downward bend effecting a downward vertical displacement from the die pad, and has a laterally spaced apart upward bend effecting an upward vertical displacement from the die pad. This package is reported to prevent imperfect encapsulation and resulting problems such as cracking of the package, and to reduce damage to the die pad, such as warping of the die pad.

Document US 5424576 A discloses a semiconductor device that includes a lead frame having tie bars. The tie bars can be used to support a semiconductor die to alleviate package cracking problems caused by stress and to provide a universal lead frame which is suitable for use with many different die sizes.

Documents such as these two latter documents thus disclose a semiconductor package with a lead frame including a die pad for mounting a semiconductor chip with tie-bars having a twice-bent structure (or, in any case, a structure bent in various shapes).

Figures 8 to 15 are illustrative of steps in manufacturing integrated circuit semiconductor devices according to embodiments of the present description, where such a structure is applied to counter diffusion of water (moisture) through the interface between a tie bar 100 and a molding compound 20, reducing the chance of delamination and package cracking.

It will be otherwise appreciated that such a sequence of steps is merely exemplary insofar as:
one or more steps illustrated in the figures can be omitted, performed in a different manner (with other tools, for instance) and/or replaced by other steps;
additional steps may be added;
one or more steps can be carried out in a sequence different from the sequence illustrated.

For simplicity and ease of explanation, in Figures 8 to 15, unless the context indicates otherwise, parts or elements like parts or elements already discussed in connection with Figures 1 to 7 are indicated in the various figures with like reference signs, and a corresponding description will not be repeated for brevity.

To summarize, Figures 8 to 15 are generally exemplary of a manufacturing process of (IC) semiconductor devices, wherein a plurality of individual leadframe portions are provided as a common electrically conductive substrate (leadframe 12) comprising a plurality of individual leadframe portions held together in a leadframe strip via connecting bars 100 ("tie bars") connecting substrate/leadframe portions (die pads 12A, for instance) to the connecting formations SL extending around the individual leadframe portions.

The tie bars 100 are formed with reduced thickness during manufacturing the sculptured electrically conductive structure (of a metal such as copper, for instance) of the leadframe 12. The tie bars 100 can be regarded as "half-etched" portions of a base metal (copper, for instance) layer or strip: as noted, referring to "half" etching does not imply that the etched depth amounts necessarily to 50% of the thickness of the metal layer or strip.

Processing as exemplified in the sequence of Figures 8 to 13 may again involve attaching semiconductor chips or dice 14 on respective die pads 12A of a leadframe 12 (here of the pre-molded type with a pre-mold resin 20A) and providing electrically conductive formations (such as wires, ribbons or clips - again not visible for simplicity in Figures 8 to 15) between the semiconductor chips or dice 14 on respective die pads 12A and the leads 12B.

An insulating encapsulation 20 (for instance, an epoxy resin, as illustrated in Figure 9) is molded on the assembly thus formed in order to complete the plastic body of a plurality of devices 10 formed on the common substrate (leadframe) 12.

As illustrated in Figure 10, these devices are finally "singulated" into individual (integrated circuit) semiconductor devices 10 by cutting (for instance, with a sawing blade B) along "horizontal" and "vertical" cutting (sawing) lines SL (thus removing the connecting formations SL).

Like in Figure 4, in Figure 10 just a piece of the common substrate 12 is visible for simplicity with one cutting line SL running between adjacent substrate portions in the common electrically conductive substrate (leadframe) 12.

These adjacent substrate portions in the common electrically conductive substrate 12 have mutually facing sides and are connected (prior to singulation) via elongated connecting bars 100 ("tie bars") connecting substrate portions (die pads 12A, for instance) to the connecting formations SL extending between the mutually facing sides.

Singulating the devices 10 into individual semiconductor devices by cutting along cutting (sawing) lines SL (thus removing the connecting formations SL) as illustrated in Figure 10 involves cutting the electrically conductive substrate 12 across the length of the elongated connecting bars 100 that are thus severed.

Said otherwise, prior to singulating the devices 10, the elongated connecting bars 100 (or tie bars) connect the electrically conductive die pads 12A to the connecting formations SL extending between adjacent substrate portions. The connecting formations SL are removed in response to the elongated connecting bars 100 being cut at the intermediate points SL.

As visible in Figures 11, 12 and 13, the singulation step results in remainders of cross-severed tie bars 100 being formed with "distal" end portions 100A left exposed at the surface of the package provided by the molding compound 20 (resin).

As discussed in the introductory portion of this description, water (moisture) infiltration into a device package during the device lifetime is observed to represent a possible source of delamination. Water (moisture) penetration may take place at tie bars 100 connecting, for instance, die pads where semiconductor chips are attached. As illustrated, remainders 100' of tie bars severed during package singulation (see Figure 10) in producing individual manufacturing semiconductor products remain that extend from the leadframe (die pads 12A) to the outer surface of the device package (molding compound 20).

In solutions as presented in Figures 8 to 15 (in contrast with the solutions discussed in the foregoing in connection with Figures 2 to 8, where the tie bars 100 - and thus the water/moisture penetration paths WPP - are essentially rectilinear) the tie bars 100 - and thus the water/moisture penetration paths, designated WPP' - have a meander-like (serpentine or snake-like) shape.

Figures 8 to 15 are illustrative of a meander-like/serpentine structure for a tie bar 100 formed in a premolded lead frame 12, by half-etching from both sides and an additional dummy pad creation.

Figures 8 to 15 are illustrative of an exemplary way of providing such a meander-like/serpentine (zig-zag) tie bar structure starting from a sheet or strip of electrically conductive material (metal such as copper, for instance) to create a substrate (leadframe) 12 by (half)etching such a sheet or strip on both opposite surfaces 121, 122.

Such processing can be carried out (in a manner known per se to those of skill in the art) forming a tie bar 100 structure having first recesses 121A and second recesses 122A that are mutually offset (staggered) in an alternate fashion along the length of the bars 100 at the opposed surfaces 121, 122 of the substrate 12.

That is:
the first recesses 121A are formed (etched) in the surface 121 at locations along the length of a tie bar 100 where the surface 122 is not etched, so that no second recesses are formed in the surface 122 at those locations, and
the second recesses 122A are formed (etched) in the surface 122 at locations along the length of a tie bar 100 where the surface 121 is not etched, so that no first recesses are formed in the surface 121 at those locations.

To summarize, in solutions as described herein a common electrically conductive substrate 12 is provided for a plurality of semiconductor devices 10; the common electrically conductive substrate 12 has mutually opposed first 121 and second 122 surfaces and comprises electrically conductive pads (die pads 12A) configured to have semiconductor chips 14 arranged thereon.

A substrate as illustrated also comprises elongated connecting bars 100 that are connected to said electrically conductive die pads 12A; these elongated connecting bars 100 are configured to be cut (see the blade B in Figure 10) at intermediate points SL along their length to provide singulated substrate portions (and individual devices.

As illustrated, the connecting (tie) bars 100 have first recesses 121A and second recesses 122A alternating along their length at the first surface 121 and at the second surface 122.

As a result of cutting at intermediate points SL (see again Figure 10), the connecting bars 100 are severed across their length and partitioned into bar remainders indicated as 100' in Figures 10, 11 and 13, for instance.

The bar remainders 100' resulting from cutting the connecting bars 100 at the intermediate points SL extend from a distal end 100A to an electrically conductive pad 12A (having one or more chips or dice 14 attached thereon) in a singulated substrate portion.

These bar remainders 100' have a serpentine pattern with at least one loop (bend or curve) between their distal end 100A (left exposed by the encapsulation of insulating material 20 and the electrically conductive pad 12A (and the one or more chips or dice 14 attached thereon).

As visible in Figure 13, with a chip 14 attached and an insulating compound 20 molded at the surface 121 of the substrate 12, a longer, tortuous penetration path WPP' is formed (at the interface between the bar remainder 100' and the encapsulation 20) : this longer, tortuous penetration path WPP' counters diffusion of water (moisture) towards the die pad 12A and the die or dice 14 attached thereon.

The longer, tortuous penetration path WPP' is formed essentially by the recessed portion or portion 121A formed in the surface 121 where molding compound (for simplicity this is indicated by 20, but pre-molding compound 20A may have the same effect) penetrates.

The number of recesses 121A, 122A formed in the surfaces 121, 122 is not limited to two and three as illustrated in the figures.

In the (purely exemplary) case presented herein, this result in the tie bars 100 exhibiting (after singulation: see Figure 13, for instance) a single scoop-like loop or bend.

An increased number of recesses 121A, 122A will result in an increased number of loops or bends (curves), that is in a "more-serpentine" tie bar shape and thus in an increasingly longer and more tortuous penetration path WPP' to counter diffusion of water (moisture) from the exposed distal end 100A towards the die pad 12A and the die or dice 14 attached thereon.

In the (purely exemplary) case presented herein, the recesses 121A, 122A are formed in the surfaces 121, 122 in a symmetrical (mirror-like) configuration with respect to the cutting line SL. While advantageous, that configuration is not mandatory.

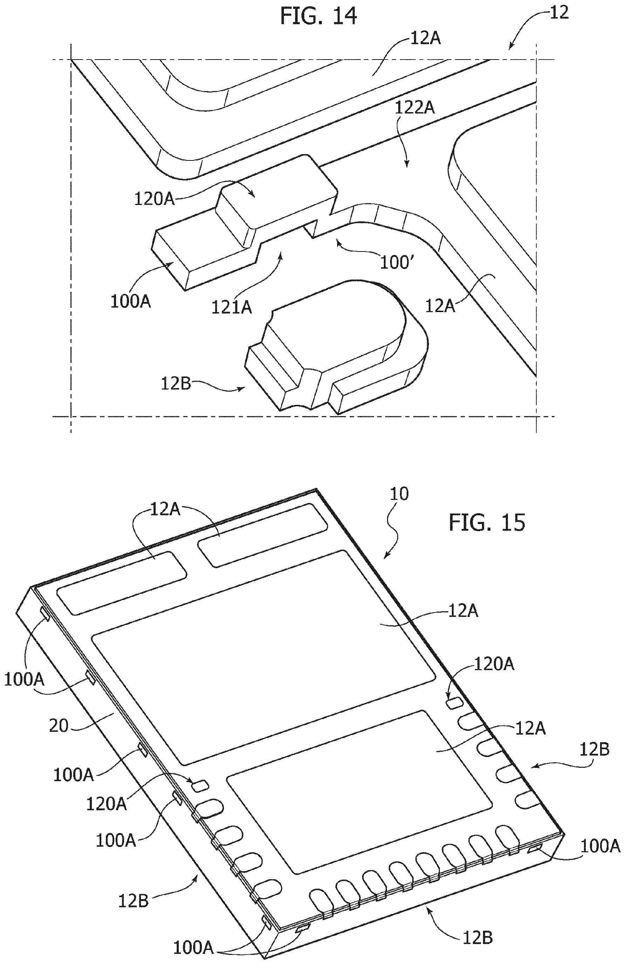

Whatever the options (for instance, number of recesses 121A, 122A, symmetrical/non-symmetrical arrangement thereof) providing a serpentine tie bar structure starting from a sheet or strip of electrically conductive material(half)etched on both opposite surfaces 121, 122 facilitates providing at the surface 122 opposite to the molding compound 20 additional pads 120A that remain exposed (uncovered) at the surface of the molding compound as visible in Figure 15, for instance.

These may be dummy pads 120A that facilitate increasing the thermo-mechanical robustness of the adjacent solder joints.

To summarize:
insulating material 20 (an epoxy resin, for instance) can be molded onto the common electrically conductive substrate 12 (prior to singulation) to encapsulate semiconductor chips 14 arranged on electrically conductive pads 12A at the first surface 121A with the elongated connecting bars 100 connected thereto; and

In response to cutting the connecting bars 100 at the intermediate points SL, the bar remainders 100' have their distal ends 100A exposed (at the encapsulation surface) and provide tortuous moisture penetration paths WPP' from the distal ends 100A to the pads 12A and the semiconductor chips 14 arranged thereon.

Advantageously, molding insulating material (possibly including pre-molding material 20A in the case of a pre-molded leadframe 12) is molded onto the common electrically conductive substrate 12.

At the second surface 122A (opposed to the first surface 121A where the chips 1 are arranged) the insulating material fills the (second) recesses 122A in the connecting bars 100 leaving the second surface 122 uncovered between the second recesses 122A.

In that way, exposed conductive substrate pads (dummy pads 120A) can be provided surfacing from the insulating material 20 as visible in Figure 15, for instance.

This can be further appreciated in Figure 14, where only the basic sculptured conductive (metal) structure of the leadframe 12 is shown with the insulating encapsulation 20 (and the pre-mold material) notionally removed.

Embodiments as discussed herein facilitate providing tie bars (by per se conventional half-etching of a metal sheet or strip, for instance) having a serpentine (meander-like) pattern.

The sheet or strip is etched at its top and bottom sides (surfaces) close to a die pad, for instance, thus maintaining an overall configuration and related properties. A resulting tie bar will be continuous with an alternation of half sections located at the top side (here the surface 121, configured to have the die/dice 14 attached thereon) and at the bottom side (here the surface 122) of a substrate (leadframe) 12.

That is the connecting bars 100 illustrated herein comprise a sequence of adjacent sections distributed along the bar length with the first recesses 121A and the second recesses 122A etched therein.

As illustrated (see Figure 8, for instance, observed from left to right) the adjacent sections in the sequence are alternately located at the first (top) surface 121 and at the second (bottom) surface 122, respectively.

Figures such as Figures 11 to 15 are thus exemplary of an (integrated circuit) semiconductor device 10 that can be manufactured using the method described herein.

As illustrated, such a device comprises (at least one) electrically conductive pad 12A having at least one semiconductor chip 14 arranged thereon plus at least one electrically conductive connecting formation, namely a remainder 100' of a connecting bar 100 bar severed (cut crosswise) at an intermediate point SL.

The bar remainder 100' extends from a distal end 100A thereof towards the pad 12A and is connected thereto.

As illustrated, the bar remainder 100' has a serpentine pattern with at least one loop between its distal end 100A and the electrically conductive pad 12A.

The bar remainder 100' has opposed first and second surfaces 121, 122 and comprises a sequence of adjacent sections having the recesses 121A, 122A etched therein (and opening outwardly of the bar remainder 100'. The adjacent sections in the sequence are alternately located at the first surface 121 and at the second surfaces 122.

A semiconductor device 10 as illustrated in Figures 11 to 15 comprises insulating material (the pre-mold resin 20A, for instance) molded onto the second surface 122 and filling the second recesses 122A therein while leaving the second surface 122 uncovered between the second recesses 122A to provide the exposed conductive substrate pads 120A surfacing from the insulating material.

That is, after molding of the encapsulation 20 at the surface 121 with the dice or chips 14 attached thereon and subsequent sawing (singulation) the tie bar 100 will give rise to two remainders 100' each having an exposed distal end 100A at the package side, with additional (dummy) pads 120A remaining exposed at the package surface (being thus visible, at the package bottom side 122, for instance).

Embodiments as discussed herein facilitate providing possible humidity penetration paths (WPP', in Figure 13) that are non-linear (snake-like) and longer, thus making more difficult for water (moisture) to penetrate a device package and create delamination likely to reach a die therein.

Embodiments as discussed herein also facilitate providing additional exposed pads (120A, in Figure 13) that increase solder joint reliability.

Embodiments as discussed herein thus reduce the possibility of having delamination primed at tie bars, while additional pads on the package may improve solder joint reliability. Reduced risk of delamination and improved solder joint reliability may thus result from embodiments as discussed herein.

Without prejudice to the underlying principles, the details and embodiments may vary, even significantly, with respect to what has been described by way of example only without departing from the extent of protection.

The extent of protection is determined by the annexed claims.

## Claims

1. A method, comprising:
providing an electrically conductive substrate (12) for a plurality of semiconductor devices (10), wherein the substrate (12) has mutually opposed first (121) and second (122) surfaces and comprises electrically conductive die pads (12A) configured to have semiconductor chips (14) arranged thereon as well as arrays of electrically conductive leads (12B) arranged around the electrically conductive die pads (12A), wherein the substrate (12) comprises elongated, electrically conductive connecting bars (100) connected to said electrically conductive die pads (12A), the elongated connecting bars (100) configured to be cut (B) at intermediate points (SL) along their length to provide singulated substrate portions,
wherein:
the elongated connecting bars (100) have distributed along their length first recesses (121A) at the first surface (121) alternating with second recesses (122A) (121A, 122A) at the second surface (122), and
in response to being cut at the intermediate points (SL), the elongated connecting bars (100) are partitioned into bar remainders (100') extending from a distal end (100A) to an electrically conductive die pad (12A) in a singulated substrate portion wherein the bar remainders (100') have a serpentine pattern with at least one loop between said distal end (100A) and said electrically conductive die pad (12A).

2. The method of claim 1, wherein the elongated connecting bars (100) connect the electrically conductive die pads (12A) to connecting formations (SL) extending between adjacent substrate portions, and wherein said connecting formations (SL) are removed in response to the elongated tie bars (100) being cut at the intermediate points (SL).

3. The method of claim 1 or claim 2, wherein the elongated connecting bars (100) comprise a sequence of adjacent sections having the first recesses (121A) and the second recesses (122A) etched therein, the adjacent sections in the sequence being alternately located at said opposed first (121) and second (122) surfaces, respectively.

4. The method of any of claims 1 to 3, wherein the first (121A) and second (122A) recesses are distributed along the length of the elongated connecting bars (100) symmetrically with respect to said intermediate points (SL) .

5. The method of any of the previous claims, comprising molding insulating material (20A) onto the second surface (122A) of the common electrically conductive substrate (12), wherein the insulating material (20A) fills the second recesses (122A) in the elongated connecting bars (100) leaving the second surface (122) uncovered between said second recesses (122A) to provide exposed conductive substrate pads (120A) surfacing from the insulating material (20A).

6. The method of any of the previous claims, comprising molding an insulating encapsulation (20) onto semiconductor chips (14) arranged on electrically conductive die pads (12A) at said first surface (121A) with said elongated connecting bars (100) connected thereto, wherein, in response to the connecting bars (100) being cut at the intermediate points (SL) said bar remainders (100') have said distal end (100A) exposed at the surface of the insulating encapsulation (20) and provide tortuous moisture penetration paths (WPP') from said distal end (100A).

7. An electrically conductive substrate (12) for use as said common electrically conductive substrate in a method according to any of claims 1 to 5, the electrically conductive substrate (12) having mutually opposed first (121) and second (122) surfaces and comprising electrically conductive die pads (12A) configured to have semiconductor chips (14) arranged thereon as well as arrays of electrically conductive leads (12B) arranged around the electrically conductive die pads (12A), wherein the substrate (12) comprises electrically conductive elongated connecting bars (100) connected to said electrically conductive die pads (12A),
wherein the elongated connecting bars (100) have distributed along their length first recesses (121A) at the first surface (121) alternating with second recesses (122A) at the second surface (122), the elongated connecting bars (100) being configured to be cut (B) at intermediate points (SL) along their length to provide singulated substrate portions and, in response to being cut at the intermediate points (SL), the elongated connecting bars (100) are partitioned into bar remainders (100') extending from a distal end (100A) to an electrically conductive die pad (12A) in a singulated substrate portion wherein the bar remainders (100') have a serpentine pattern with at least one loop between said distal end (100A) and said electrically conductive die pad (12A).

8. The substrate of claim 7, wherein the elongated connecting bars (100) connect the electrically conductive die pads (12A) to connecting formations (SL) extending between adjacent substrate portions, and wherein said connecting formations (SL) are removed in response to the elongated tie bars (100) being cut at the intermediate points (SL).

9. The substrate of claim 7 or claim 8, wherein the elongated connecting bars (100) comprise a sequence of adjacent sections having the first recesses (121A) and the second recesses (122A) etched therein, the adjacent sections in the sequence being alternately located at said opposed first (121) and second (122) surfaces, respectively.

10. The substrate (12) of any of claims 7 to 9, wherein the first (121A) and second (122A) recesses in the elongated connecting bars (100) at the first surface (121) and at the second surface (122) of the electrically conductive substrate (12) are arranged symmetrically with respect to said intermediate points (SL).

11. The substrate of any of claims 7 to 10, comprising insulating material (20A) molded onto at the second surface (122A) of the common electrically conductive substrate (12), wherein the insulating material (20, 20A) fills said second recesses (122A) in the elongated connecting bars (100) leaving the second surface (122) uncovered between said second recesses (122A) to provide exposed conductive substrate pads (120A) surfacing from the insulating material (20A).

12. A semiconductor device (10), comprising an electrically conductive die pad (12A) having at least one semiconductor chip (14) arranged thereon as well as arrays of electrically conductive leads (12B) arranged around the electrically conductive die pads (12A), wherein the semiconductor device (10) comprises at least one electrically conductive connecting formation (100') extending from a distal end (100A) towards the electrically conductive pad (12A), the electrically conductive formation (100') being connected to the electrically conductive die pad (12A) and having a serpentine pattern with at least one loop between said distal end (100A) and said electrically conductive die pad (12A).

13. The semiconductor device (10) of claim 12, wherein the electrically conductive formation (100') has opposed first (121) and second (122) surfaces and comprises a sequence of adjacent sections having recesses (121A, 122A) etched therein, the adjacent sections in the sequence being alternately located at said opposed first (121) and second (122) surfaces, respectively.

14. The semiconductor device (10) of claim 13, comprising insulating material (20A) molded onto the second surface (122) and filling recesses (122A) in said second surface while leaving the second surface (122) uncovered between said second recesses (122A) to provide exposed conductive substrate pads (120A) surfacing from the insulating material (20A).
